# EUROPÄISCHE PATENTSCHRIFT

(11) **EP 3 367 769 B1**
(45) Veröffentlichungstag und Bekanntmachung des Hinweises auf die Patenterteilung: **13.03.2024**
(21) Anmeldenummer: 18155720.8
(22) Anmeldetag: 08.02.2018
(51) Int. Cl.: H05K 7/20

(54) **VORRICHTUNG ZUR AUFNAHME EINER ELEKTRONIK**
DEVICE FOR HOLDING AN ELECTRONICS SYSTEM
DISPOSITIF DE RÉCEPTION D'UNE ÉLECTRONIQUE

(30) Priorität: 27.02.2017 DE 102017104007
(43) Veröffentlichungstag der Anmeldung: 29.08.2018
(73) Patentinhaber: Krohne Messtechnik GmbH, 47058 Duisburg (DE)
(72) Erfinder: Brockhaus, Helmut, 46145 Oberhausen (DE); Erkelenz, Alexander, 47447 Moers (DE); Matt, Achim, 47055 Duisburg (DE)
(74) Vertreter: Gesthuysen Patentanwälte

(56) Entgegenhaltungen:
- DE-A1-102012 110 001
- US-A1- 2004 007 348
- US-A1- 2012 134 114
- US-A1- 2012 161 596
- US-A1- 2015 271 950

## Beschreibung

Die Erfindung geht aus von einer Vorrichtung zur Aufnahme einer Elektronik umfassend ein geschlossenes Gehäuse mit einer Gehäusewand, wenigstens ein Elektronikbauteil und einen Lüfter mit einem Lüftergehäuse, wobei das Elektronikbauteil und der Lüfter innerhalb des Gehäuses angeordnet sind.

Aus dem Stand der Technik ist es bekannt, Elektronikbauteile, die in einem Gehäuse angeordnet sind, mittels eines Lüfters im Betrieb zu kühlen. Dazu weist das Gehäuse meist Öffnungen auf, um einen Luftaustausch zwischen dem Gehäuseinneren und der Umgebung zu ermöglichen. Durch den Einsatz eines Lüfters kann so die warme Luft des Gehäuseinneren aus dem Gehäuse abgeleitet werden.

Es gibt jedoch Anwendungsfälle, in denen der Einsatz von offenen Gehäusen nicht möglich ist. Unterliegt das Gehäuse beispielsweise erhöhten Anforderungen bezüglich des Explosionsschutzes oder bezüglich der Reinheit des Gehäuseinneren, ist das Gehäuse geschlossen ausgestaltet. Ein Luftaustausch mit der Umgebung zur Kühlung der innerhalb des Gehäuses angeordneten Komponenten ist insofern nicht möglich.

In dieser Ausgestaltung kann eine Kühlung beispielsweise durch den Einsatz von Kühlkörpern, die auf den sich erwärmenden Bauteilen angeordnet sind, erfolgen. Der Kühlkörper leitet die an den Bauteilen anfallende Verlustwärme von diesen Bauteilen weg und gibt sie durch Konvektion an die Umgebung ab.

Alternativ dazu offenbart die Druckschrift EP 2 197 255 A1 ein geschlossenes Gehäusesystem, bei dem die Luft des Gehäuseinneren mittels eines Schwingmembranlüfters verwirbelt und somit von lokalen Wärmequellen abgeleitet wird.

Die Druckschrift US 2015/271950 A1 betrifft ein geschlossenes Gehäuse umfassend einen Lüfter zur Kühlung der Elektronikbauteile, wobei die Luft innerhalb des Gehäuses zirkuliert und über Verbindungskanäle abgekühlt wird.

Aus der Druckschrift DE 10 2012 110 001 A1 ist zudem eine Vorrichtung umfassend ein geschlossenes Gehäuse mit einer Gehäusewand bekannt, wobei die Vorrichtung weiterhin wenigstens ein Elektronikbauteil und einen Lüfter mit einem Lüftergehäuse umfasst, wobei das Elektronikbauteil und der Lüfter innerhalb des Gehäuses angeordnet sind. Der Lüfter ist zur Kühlung von im Innenraum des geschlossenen Gehäuses angeordneten Elementen unmittelbar an der seitlichen Gehäusewand angeordnet.

Ausgehend von dem dargelegten Stand der Technik ist es Aufgabe der Erfindung eine Vorrichtung zur Aufnahme einer Elektronik anzugeben, die eine alternative Kühlung der Elektronik in einem geschlossenen Gehäuse ermöglicht.

Gemäß der Lehre der Erfindung ist die Aufgabe bei der eingangs genannten Vorrichtung dadurch gelöst, dass der Lüfter als Ventilator ausgestaltet ist und dass der Lüfter im Betrieb einen kontinuierlichen, insbesondere einen gleichbleibenden Luftstrom zur Kühlung der Elektronik erzeugt, wobei das Elektronikbauteil auf wenigstens einer Leiterplatte angeordnet ist,
wobei wenigstens eine Halterung vorhanden ist, wobei die Halterung innerhalb des Gehäuses angeordnet ist, wobei der Lüfter in der Halterung angeordnet ist,
wobei mehr als eine Leiterplatte vorhanden ist und wobei wenigstens ein Verbindungselement zur Verbindung und/oder zur Aufnahme der Leiterplatten vorhanden ist und wobei die Halterung mit dem Verbindungselement verbunden ist,
wobei das Verbindungselement als Leiterplatte, die als Rückwand im Gehäuseinneren angeordnet ist, ausgestaltet ist,
wobei wenigstens ein Kanalisierungselement vorhanden ist, wobei das Kanalisierungselement derart angeordnet ist, dass der Luftstrom im Betrieb von dem Lüfter über das Kanalisierungselement in das Gehäuse strömt, wobei das Kanalisierungselement teilweise durch die Halterung und teilweise durch das Verbindungselement gebildet wird,
wobei ein Geräteeinsatz oder eine Mehrzahl von unabhängigen Leiterplatten mit der als Rückwand ausgestalteten Leiterplatte verbunden ist, wobei der Lüfter derart angeordnet ist, dass der Luftstrom zumindest teilweise zwischen den Leiterplatten entlang strömt.

Erfindungsgemäß wurde erkannt, dass ein Ventilator in einem geschlossenen Gehäuse dazu eingesetzt werden kann, einen Luftstrom in Form einer Zirkulation zu erzeugen, wodurch eine Kühlung der im Gehäuseinneren angeordneten Elektronikbauteile erreicht werden kann. Dies hat den Vorteil, dass im Betrieb eine kontinuierliche und effektive Kühlung gewährleistet werden kann. Es können insbesondere verschiedene galvanisch getrennte Bereiche durch den erfindungsgemäßen Einsatz des Kühlers gekühlt werden. Das Lüftergehäuse ist vorzugsweise derart ausgestaltet, dass der angesaugte Luftstrom kanalisiert umgeleitet wird. Besonders vorteilhaft ist es, wenn der Lüfter derart ausgestaltet und angeordnet ist, dass der Luftstrom zur Kühlung an wenigstens einem kühlenden Element, insbesondere der Gehäusewand, entlang geleitet wird.

Erfindungsgemäß ist das Elektronikbauteil auf wenigstens einer Leiterplatte angeordnet. Sind mehrere Leiterplatten vorhanden, so sind diese entweder als kompakter Geräteeinsatz gruppiert oder sie werden separat, also unabhängig voneinander, in dem Gehäuse angeordnet. Dabei wird der Luftstrom im Betrieb der Vorrichtung derart zwischen die Leiterplatten geleitet, dass die sich im Betrieb erwärmenden Bauteile auf den Leiterplatten effektiv gekühlt werden.

Erfindungsgemäß ist mehr als eine Leiterplatte vorhanden und es ist wenigstens ein vorzugsweise leitfähiges Verbindungselement zur Verbindung und/oder zur Aufnahme der Leiterplatten vorhanden, wobei die Halterung mit dem Verbindungselement verbunden ist. Dabei ist es besonders bevorzugt, wenn die Halterung lösbar mit dem Verbindungselement verbunden ist. Besonders bevorzugt ist die Halterung formschlüssig mit dem Verbindungselement verbunden. Dazu weist das Verbindungselement vorzugsweise wenigstens eine Aussparung zur Aufnahme der Halterung auf. Alternativ kann die Halterung auch über eine Schraubverbindung mit dem Verbindungselement verbunden sein. Denkbar ist es ebenfalls, dass die Halterung stoffschlüssig mit dem Verbindungselement verbunden ist oder dass die Halterung einstückig mit dem Verbindungselement ausgestaltet ist.

Das Verbindungselement ist als Leiterplatte ausgestaltet. Erfindungsgemäß ist die Leiterplatte als Rückwand im Gehäuseinneren also neben der Gehäusewand angeordnet und weist insbesondere Steckplätze zur Aufnahme eines Geräteeinsatzes bestehend aus mit elektronischen Bauteilen bestückten Leiterplatten auf.

Ist ein Geräteeinsatz oder eine Mehrzahl von unabhängigen Leiterplatten mit einer als Rückwand ausgestalteten Leiterplatte verbunden, so ist der Lüfter derart angeordnet, dass der Luftstrom zumindest teilweise zwischen den Leiterplatten entlang strömt.

Gemäß einer weiteren Ausgestaltung ist der Lüfter zur Energieversorgung leitfähig mit der Leiterplatte und/oder dem Verbindungselement verbunden. Die Verbindung erfolgt beispielsweise mittels Schneid-Klemm-Kontakten.

Gemäß einer weiteren Ausgestaltung besteht das Lüftergehäuse zumindest teilweise aus einem Metall. Vorteilhaft ist es, wenn das Material des Lüftergehäuses eine hohe Wärmeleitfähigkeit aufweist, sodass der Lüfter über das Lüftergehäuse gekühlt werden kann.

In einer weiteren vorteilhaften Ausgestaltung der erfindungsgemäßen Vorrichtung ist das Lüftergehäuse über ein Kopplungsmittel thermisch mit der Gehäusewand gekoppelt oder das Lüftergehäuse weist unmittelbaren Kontakt mit der Gehäusewand auf. Dies hat den Vorteil, dass der Lüfter und damit der Luftstrom über das Lüftergehäuse und den Kontakt mit der kühlen Gehäusewand gekühlt werden kann. Dieser Vorteil ergibt sich insbesondere dann, wenn das Material des Lüftergehäuses eine hohe Wärmeleitfähigkeit aufweist, also beispielsweise aus einem Metall besteht. Unter einem unmittelbaren Kontakt wird vorliegend verstanden, dass keine weiteren Komponenten zwischen dem Lüftergehäuse und der Gehäusewand angeordnet sind.

Vorzugsweise umfasst das Kopplungsmittel eine Wärmeleitmatte, ein Wärmeleitpad, eine Wärmeleitpaste oder Wärmeleitklebstoff.

Erfindungsgemäß ist wenigstens ein Kanalisierungselement, insbesondere in Form eines Luftkanals, vorhanden, wobei das Kanalisierungselement derart angeordnet ist, dass der Luftstrom im Betrieb von dem Lüfter über das Kanalisierungselement in das Gehäuse strömt. Mittels des Kanalisierungselementes kann der Luftstrom gezielt zu den Elektronikbauteilen geführt werden, die sich im Betrieb besonders stark erwärmen. Insofern weist diese Ausgestaltung den Vorteil auf, dass eine gezielte kontrollierte Kühlung der Elektronik erfolgen kann. Beispielsweise ist das Kanalisierungselement als Luftkanal oder als kanalisierter Ventilatorausgang ausgestaltet.

Eine weitere Ausgestaltung ist dadurch gekennzeichnet, dass das Kanalisierungselement derart ausgestaltet und angeordnet ist, dass das Kanalisierungselement zumindest teilweise an der Gehäusewand entlang verläuft. Dabei kann das Kanalisierungselement mit geringem Abstand vorzugsweise parallel zur Gehäusewand verlaufen oder unmittelbaren Kontakt zur Gehäusewand aufweisen. Diese Ausgestaltung weist den Vorteil auf, dass eine besonders effektive Kühlung des Luftstroms im Bereich des Kanalisierungselements erreicht werden kann. Dies gilt insbesondere, wenn das Kanalisierungselement unmittelbaren Kontakt mit der Gehäusewand aufweist. Denn durch den Kontakt mit der kühlen Gehäusewand kann die von dem Luftstrom aufgenommene Wärme effektiv über das Gehäuse abgeführt werden.

Erfindungsgemäß wird das Kanalisierungselement zumindest teilweise durch die Halterung gebildet. Dies hat den Vorteil, dass das Kanalisierungselement unmittelbar an dem Lüfter angeordnet ist.

Erfindungsgemäß wird das Kanalisierungselement zumindest teilweise durch das Verbindungselement gebildet.

Besonders bevorzugt ist es, wenn ein Teil des Kanalisierungselementes durch die Halterung gebildet wird und das Kanalisierungselement durch das Verbindungselement vervollständigt wird.

Gemäß einer weiteren Ausgestaltung besteht die Halterung zumindest teilweise aus einem Polymer. Vorteilhaft ist es allgemein, wenn die Halterung aus einem Material mit geringer Wärmeleitfähigkeit besteht. Denn dann wird in dem Fall, in dem die Halterung Kontakt mit dem Verbindungselement aufweist, keine Wärme von der Halterung auf das Verbindungselement übertragen.

Gemäß einer nächsten bevorzugten Ausgestaltung ist eine Regelungseinheit, vorzugsweise ein Mikrocontroller, vorhanden, wobei die Regelungseinheit die Drehzahl des Lüfters im Betrieb regelt. Dabei ist der Lüfter vorzugsweise derart ausgestaltet, dass er stufenlos oder diskret geregelt werden kann. Beispielsweise ist die Regelungseinheit auf einer Leiterplatte angeordnet.

Besonders bevorzugt ist die Regelungseinheit derart ausgestaltet, dass sie im Betrieb die Drehzahl des Lüfters in Abhängigkeit von der Temperatur innerhalb des Gehäuses regelt. Besonders bevorzugt regelt die Regelungseinheit die Drehzahl des Lüfters in Abhängigkeit von der Differenz zwischen der Temperatur innerhalb des Gehäuses und der Temperatur außerhalb des Gehäuses oder einer erfassten Gehäusewandtemperatur.

Gemäß einer weiteren Ausgestaltung ist das Gehäuse als Ex-d - Gehäuse ausgestaltet. Das Gehäuse erfüllt damit besondere Anforderungen in Bezug auf den Explosionsschutz. Beispielsweise ist das Gehäuse ein Transmittergehäuse zur Anbindung an eine Sensoreinheit.

Im Einzelnen gibt es nun eine Vielzahl von Möglichkeiten die erfindungsgemäße Vorrichtung auszugestalten und weiterzubilden. Dazu wird verwiesen sowohl auf die dem unabhängigen Patentanspruch nachgeordneten Patentansprüche als auch auf die nachfolgende Beschreibung von bevorzugten Ausführungsbeispielen in Verbindung mit der Zeichnung. In der Zeichnung zeigen
- Fig. 1: eine Schnittdarstellung eines ersten Ausführungsbeispiels der erfindungsgemäßen Vorrichtung,
- Fig. 2: eine Darstellung des Lüfters in der Halterung,
- Fig. 3: eine Darstellung des Lüfters in der Halterung und dem Verbindungselement in Form einer Leiterplatte und
- Fig. 4: einen Geräteeinsatz zur Anbindung an die Leiterplatte.

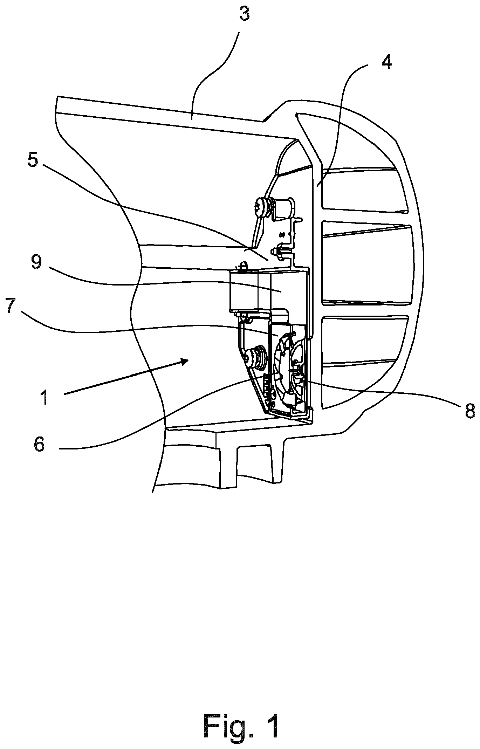

Fig. 1 zeigt eine Schnittdarstellung eines ersten Ausführungsbeispiels einer Vorrichtung 1 zur Aufnahme einer Elektronik. Dargestellt ist ein Ex-d - Gehäuse 3 mit einer Gehäusewand 4, einer Halterung 5 und einem Lüfter 6 mit einem Lüftergehäuse 7, wobei der Lüfter 6 in der Halterung 5 angeordnet ist. Dazu weist die Halterung 5 eine Ausnehmung auf, in der der Lüfter 6 und das Lüftergehäuse 7 angeordnet sind. Der Lüfter 6 ist als Ventilator 6 ausgestaltet und erzeugt im Betrieb einen kontinuierlichen Luftstrom zur Kühlung der hier nicht dargestellten Elektronik.

Das Lüftergehäuse 7 ist aus einem Metall. Zur Ableitung der Wärme ist das Lüftergehäuse 7 über eine Wärmeleitmatte 8 mit der Gehäusewand 4 verbunden.

Zudem ist ein Kanalisierungselement 9 in Form eines Luftkanals 9 vorhanden, über den der Luftstrom im Betrieb von dem Lüfter 6 in das Gehäuse 3 strömt. Dabei verläuft der Luftkanal 9 teilweise entlang der Gehäusewand 4, wodurch eine effektive Kühlung des durch den Luftkanal 9 strömenden Luftstroms erreicht wird.

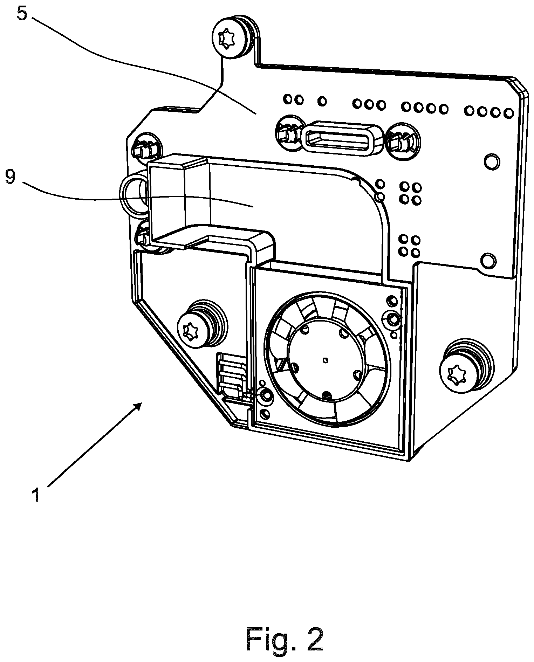

Fig. 2 zeigt eine Darstellung des Lüfters 6 in der Halterung 5. Der in Fig. 2 gezeigten Ansicht lässt sich insbesondere der Verlauf des Luftkanals 9 entnehmen. Die Darstellung zeigt, dass der Luftstrom zunächst parallel der Gehäusewand 4 und anschließend über den Kanalausgang in das Gehäuseinnere geleitet wird.

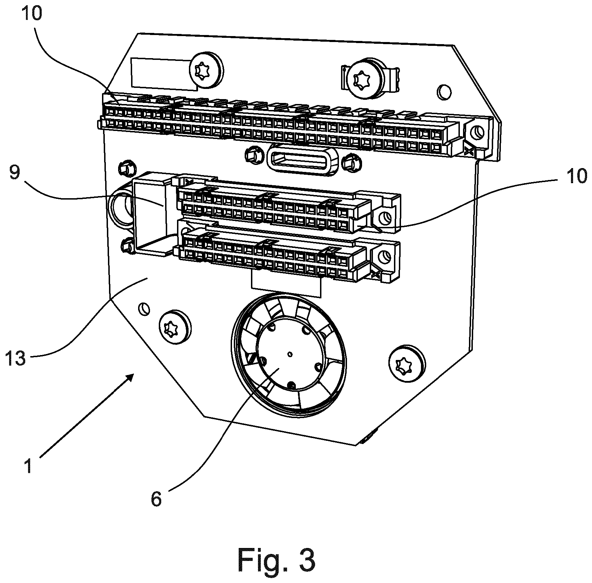

Fig. 3 zeigt eine Darstellung des Lüfters 6 in der Halterung 5 und dem Verbindungselement 13 in Form einer Leiterplatte. Die Leiterplatte ist lösbar mit der Halterung 5 dadurch verbunden, dass die Halterung 5 in die Leiterplatte eingeclipst ist.

Zudem ist der Lüfter 6 zur Energieversorgung und zur Regelung durch Schneid-Klemm-Kontakte leitfähig mit der Leiterplatte verbunden. Der Luftkanal 9 wird teilweise durch die Halterung 5, wie auch in den Fig. 1 und 2 dargestellt, gebildet und durch die Leiterplatte vervollständigt. Dabei besteht die Halterung 5 aus einem Polymer, um eine Wärmeübertragung von der Halterung 5 auf die Leiterplatte zu vermeiden.

Die dargestellte Leiterplatte ist zur Verwendung als Rückwand innerhalb des Gehäuses ausgestaltet und weist Steckplätze 10 zur Aufnahme eines Geräteeinsatzes 11 bestehend aus weiteren mit elektronischen Bauteilen bestückten Leiterplatten 2 auf.

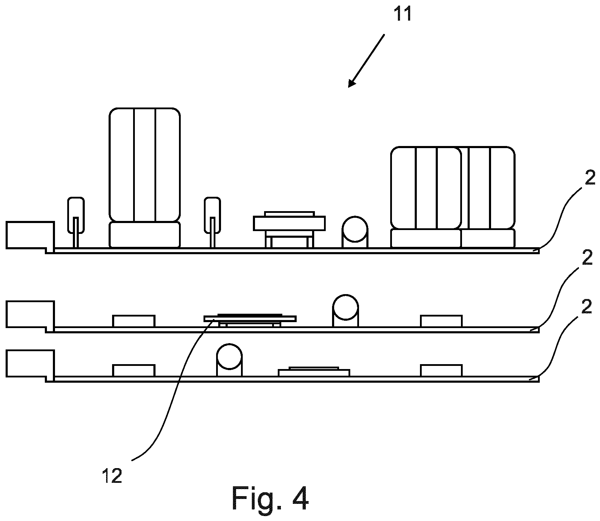

Ein solcher Geräteeinsatz 11 bestehend aus mehreren mit elektronischen Bauteilen bestückten Leiterplatten 2 ist in Fig. 4 dargestellt. Auf dem Geräteeinsatz 11 ist ebenfalls eine Regelungseinheit 12 in Form eines Mikrocontrollers angeordnet, der die Drehzahl des Lüfters 6 in Abhängigkeit von der Temperatur innerhalb des Gehäuses 3 regelt.

### Bezugszeichen

- 1: Vorrichtung zur Aufnahme einer Elektronik
- 2: Leiterplatte
- 3: Gehäuse
- 4: Gehäusewand
- 5: Halterung
- 6: Lüfter
- 7: Lüftergehäuse
- 8: Wärmeleitmatte
- 9: Kanalisierungselement
- 10: Steckplätze
- 11: Geräteeinsatz
- 12: Regelungseinheit
- 13: Verbindungselement

## Patentansprüche

1. Vorrichtung (1) zur Aufnahme einer Elektronik (2) umfassend ein geschlossenes Gehäuse (3) mit einer Gehäusewand (4), wenigstens ein Elektronikbauteil und einen Lüfter (6) mit einem Lüftergehäuse (7), wobei das Elektronikbauteil und der Lüfter (6) innerhalb des Gehäuses (3) angeordnet sind, wobei der Lüfter (6) als Ventilator (6) ausgestaltet ist, wobei der Lüfter (6) im Betrieb einen kontinuierlichen Luftstrom zur Kühlung des Elektronikbauteils erzeugt und wobei das Elektronikbauteil auf wenigstens einer Leiterplatte (2) angeordnet ist,
wobei wenigstens eine Halterung (5) vorhanden ist, wobei die Halterung (5) innerhalb des Gehäuses (3) angeordnet ist, wobei der Lüfter (6) in der Halterung (5) angeordnet ist,
wobei mehr als eine Leiterplatte (2) vorhanden ist und wobei wenigstens ein Verbindungselement (13) zur Verbindung und/oder zur Aufnahme der Leiterplatten (2) vorhanden ist und wobei die Halterung (5) mit dem Verbindungselement (13) verbunden ist,
**dadurch gekennzeichnet,**
**dass** das Verbindungselement (13) als Leiterplatte, die als Rückwand im Gehäuseinneren angeordnet ist, ausgestaltet ist,
**dass** wenigstens ein Kanalisierungselement (9) vorhanden ist, wobei das Kanalisierungselement (9) derart angeordnet ist, dass der Luftstrom im Betrieb von dem Lüfter (6) über das Kanalisierungselement (9) in das Gehäuse (3) strömt, wobei das Kanalisierungselement (9) teilweise durch die Halterung (5) und teilweise durch das Verbindungselement (13) gebildet wird,
**dass** ein Geräteeinsatz (11) oder eine Mehrzahl von unabhängigen Leiterplatten (2) mit der als Rückwand ausgestalteten Leiterplatte verbunden ist, wobei der Lüfter (6) derart angeordnet ist, dass der Luftstrom zumindest teilweise zwischen den Leiterplatten (2) entlang strömt.

2. Vorrichtung (1) nach Anspruch 1, **dadurch gekennzeichnet, dass** der Lüfter (6) leitfähig mit der Leiterplatte (2) und/oder dem Verbindungselement (13) verbunden ist.

3. Vorrichtung (1) nach einem der Ansprüche 1 oder 2, **dadurch gekennzeichnet, dass** das Lüftergehäuse (7) zumindest teilweise aus einem Metall besteht.

4. Vorrichtung (1) nach einem der Ansprüche 1 bis 3, **dadurch gekennzeichnet, dass** das Lüftergehäuse (7) über ein Kopplungsmittel (8) thermisch mit der Gehäusewand (4) gekoppelt ist oder unmittelbaren Kontakt mit der Gehäusewand (4) aufweist.

5. Vorrichtung (1) nach Anspruch 4, **dadurch gekennzeichnet, dass** das Kopplungsmittel (8) eine Wärmeleitmatte (8), ein Wärmeleitpad oder eine Wärmeleitpaste umfasst.

6. Vorrichtung (1) nach einem der Ansprüche 1 bis 5, **dadurch gekennzeichnet, dass** das Kanalisierungselement (9) derart ausgestaltet und angeordnet ist, dass das Kanalisierungselement (9) zumindest teilweise an der Gehäusewand (4) entlang verläuft.

7. Vorrichtung (1) nach einem der Ansprüche 1 bis 6, **dadurch gekennzeichnet, dass** die Halterung (5) zumindest teilweise aus einem Polymer besteht.

8. Vorrichtung (1) nach einem der Ansprüche 1 bis 7, **dadurch gekennzeichnet, dass** eine Regelungseinheit (12), vorzugsweise ein Mikrocontroller (12), vorhanden ist, wobei die Regelungseinheit (12) die Drehzahl des Lüfters (6) im Betrieb regelt.

9. Vorrichtung (1) nach Anspruch 8, **dadurch gekennzeichnet, dass** die Regelungseinheit (12) derart ausgestaltet ist, dass sie im Betrieb die Drehzahl des Lüfters (6) in Abhängigkeit von der Temperatur innerhalb des Gehäuses (3) regelt.

10. Vorrichtung (1) nach einem der Ansprüche 1 bis 9, **dadurch gekennzeichnet, dass** das Gehäuse (3) als Ex-d - Gehäuse ausgestaltet ist.

## Claims

1. Device (1) for accommodating an electronic component (2), comprising a closed housing (3) with a housing wall (4), at least one electronic component and a fan (6) with a fan housing (7), wherein the electronic component and the fan (6) are arranged inside the housing (3), wherein the fan (6) is designed as a ventilator (6), wherein the fan (6) generates a continuous air flow for cooling the electronic component during operation and wherein the electronic component is arranged on at least one printed circuit board (2)
wherein at least one holder (5) is present, wherein the holder (5) is arranged inside the housing (3), wherein the fan (6) is arranged in the holder (5),
wherein more than one printed circuit board (2) is provided and wherein at least one connecting element (13) is provided for connecting and/or receiving the printed circuit boards (2) and wherein the holder (5) is connected to the connecting element (13),
**characterized in**
**that** the connecting element (13) is designed as a printed circuit board which is arranged as a rear wall inside the housing,
**that** at least one ducting element (9) is present, wherein the ducting element (9) is arranged such that the air flow flows from the fan (6) into the housing (3) via the ducting element (9) during operation, wherein the ducting element (9) is formed partly by the holder (5) and partly by the connecting element (13),
**that** a device insert (11) or a plurality of independent circuit boards (2) is connected to the circuit board designed as a rear wall, wherein the fan (6) is arranged in such a way that the air flow flows at least partially between the circuit boards (2).

2. Device (1) according to claim 1, **characterized in that** the fan (6) is conductively connected to the printed circuit board (2) and/or the connecting element (13).

3. Device (1) according to any one of claims 1 or 2, **characterized in that** the fan housing (7) is at least partially made of a metal.

4. Device (1) according to any one of claims 1 to 3, **characterized in that** the fan housing (7) is thermally coupled to the housing wall (4) via a coupling means (8) or is in direct contact with the housing wall (4).

5. Device (1) according to claim 4, **characterized in that** the coupling means (8) comprises a thermally conductive mat (8), a thermally conductive pad or a thermally conductive paste.

6. Device (1) according to any one of claims 1 to 5, **characterized in that** the ducting element (9) is designed and arranged in such a way that the ducting element (9) runs at least partially along the housing wall (4).

7. Device (1) according to any one of claims 1 to 6, **characterized in that** the holder (5) consists at least partially of a polymer.

8. Device (1) according to any one of claims 1 to 7, **characterized in that** a control unit (12), preferably a microcontroller (12), is provided, wherein the control unit (12) controls the speed of the fan (6) during operation.

9. Device (1) according to claim 8, **characterized in that** the control unit (12) is designed in such a way that it controls the speed of the fan (6) during operation depending on the temperature inside the housing (3).

10. Device (1) according to any one of claims 1 to 9, **characterized in that** the housing (3) is designed as an Ex-d housing.

## Revendications

1. Dispositif (1) permettant de recevoir une électronique (2), comprenant un boîtier fermé (3) pourvu d'une paroi de boîtier (4), au moins un composant électronique et un aérateur (6) pourvu d'un boîtier d'aérateur (7), dans lequel le composant électronique et l'aérateur (6) sont disposés à l'intérieur du boîtier (3), dans lequel l'aérateur (6) est configuré sous forme de ventilateur (6), dans lequel l'aérateur (6) génère en cours de fonctionnement un flux d'air continu pour refroidir le composant électronique, et dans lequel le composant électronique est disposé sur au moins une carte de circuits imprimés (2),
dans lequel au moins un support (5) est présent, le support (5) étant disposé à l'intérieur du boîtier (3), l'aérateur (6) étant disposé dans le support (5), dans lequel plus d'une carte de circuits imprimés (2) est présente, et dans lequel au moins un élément de liaison (13) est présent pour relier et/ou recevoir les cartes de circuits imprimés (2), et dans lequel le support (5) est relié à l'élément de liaison (13),
**caractérisé**
**en ce que** l'élément de liaison (13) est configuré sous la forme d'une carte de circuits imprimés qui est disposée en tant que paroi arrière à l'intérieur du boîtier,
**en ce qu'**au moins un élément de canalisation (9) est présent, dans lequel l'élément de canalisation (9) est disposé de telle sorte qu'en cours de fonctionnement le flux d'air s'écoule de l'aérateur (6) dans le boîtier (3) en passant par l'élément de canalisation (9), l'élément de canalisation (9) étant formé en partie par le support (5) et en partie par l'élément de liaison (13),
**en ce qu'**un insert pour appareil (11) ou une pluralité de cartes de circuits imprimés indépendantes (2) est relié(e) à la carte de circuits imprimés configurée en tant que paroi arrière, l'aérateur (6) étant disposé de telle sorte que le flux d'air s'écoule au moins en partie entre les cartes de circuits imprimés (2).

2. Dispositif (1) selon la revendication 1, **caractérisé en ce que** l'aérateur (6) est relié de manière conductrice à la carte de circuits imprimés (2) et/ou à l'élément de liaison (13).

3. Dispositif (1) selon l'une quelconque des revendications 1 ou 2, **caractérisé en ce que** le boîtier d'aérateur (7) est au moins en partie composé d'un métal.

4. Dispositif (1) selon l'une quelconque des revendications 1 à 3, **caractérisé en ce que** le boîtier d'aérateur (7) est couplé thermiquement à la paroi de boîtier (4) par l'intermédiaire d'un un moyen de couplage (8) ou se trouve en contact direct avec la paroi de boîtier (4).

5. Dispositif (1) selon la revendication 4, **caractérisé en ce que** le moyen de couplage (8) comprend un tapis thermique (8), un pad thermique ou une pâte thermique.

6. Dispositif (1) selon l'une quelconque des revendications 1 à 5, **caractérisé en ce que** l'élément de canalisation (9) est configuré et disposé de telle sorte que l'élément de canalisation (9) s'étend au moins en partie le long de la paroi de boîtier (4).

7. Dispositif (1) selon l'une quelconque des revendications 1 à 6, **caractérisé en ce que** le support (5) est au moins en partie composé d'un polymère.

8. Dispositif (1) selon l'une quelconque des revendications 1 à 7, **caractérisé en ce qu'**une unité de régulation (12), de préférence un microcontrôleur (12), est présente, dans lequel l'unité de régulation (12) régule la vitesse de rotation de l'aérateur (6) en cours de fonctionnement.

9. Dispositif (1) selon la revendication 8, **caractérisé en ce que** l'unité de régulation (12) est configurée de telle sorte qu'elle régule en cours de fonctionnement la vitesse de rotation de l'aérateur (6) en fonction de la température à l'intérieur du boîtier (3) .

10. Dispositif (1) selon l'une quelconque des revendications 1 à 9, **caractérisé en ce que** le boîtier (3) est configuré en tant que boîtier Ex-d.
